# EUROPEAN PATENT APPLICATION

(11) **EP 4 417 985 A1**
(43) Date of publication of application: **21.08.2024**
(21) Application number: 24157301.3
(22) Date of filing: 13.02.2024
(51) Int. Cl.: G01R 31/28, H01L 21/66, G01R 31/26

(54) **SEMICONDUCTOR DEVICE WITH PAD CONTACT FEATURE AND METHOD THEREFOR**

(30) Priority: 17.02.2023 US 202318170581
(71) Applicant: NXP USA, Inc., Austin TX 78735 (US)
(72) Inventor: Uehling, Trent, 5656AG Eindhoven (NL)
(74) Representative: Miles, John Richard

(57) **Abstract**

A method of manufacturing a semiconductor device (100) is provided. The method includes forming a conductive probe plug (302) on an exposed portion of a die pad (204) of a semiconductor die by way of an electroless plating process. A top surface (304) of the conductive probe plug (302) extends above a top surface (216) of a top passivation layer (212) of the semiconductor die. A copper pillar (702) is formed over the conductive probe plug (302) by way of an electrolytic plating process. Outer sidewalls of the copper pillar (702) surround the top surface (304) of the conductive probe plug (302). A top surface (704) of the copper pillar (702) is plated with a solder plate material (802) and reflowed to form a solder cap (902) on the top of the copper pillar (702).

## Description

### Background

### Field

This disclosure relates generally to semiconductor device packaging, and more specifically, to a semiconductor device with a die pad contact feature and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified plan view, an example semiconductor device having a die pad contact structure in accordance with an embodiment.
FIG. 2 through FIG. 9 illustrate, in simplified cross-sectional views, the example semiconductor device taken along line A-A of FIG. 1 at stages of manufacture in accordance with an embodiment.

### Detailed Description

In a conventional manufacturing flow for flip chip devices, copper pillars may be incorporated at die pads of die sites while in wafer form. Wafer level probe testing of such devices is performed by contacting solder tips of the copper pillars with probe needles of a probe test apparatus. For some products incorporating these devices, extended operating temperature ranges are desirable. Accordingly, wafer probe testing at an elevated temperature such as 150 degrees Celsius may be required. When probe testing is performed at or near 150 °C, the solder tips of the copper pillars are more susceptible to deformation and damage as the high temperature testing is near the melting point of the solder. As successive die sites are probed, an accumulation of solder on probe needle tips may become a form of contamination and require more frequent maintenance and cleaning cycles of the probe needles, for example.

Generally, there is provided, a semiconductor device with a die pad contact feature. The die pad contact feature of the semiconductor device includes a raised conductive probe plug formed on die pads of a semiconductor die. Each conductive probe plug is formed by electroless (maskless) plating a nickel material on an exposed portion of a die pad. A top surface of each conductive probe plug extends above a top surface of a top passivation layer of the semiconductor die to facilitate high temperature wafer level probe testing with flat probe needle tips. In this manner, high temperature probe testing may be performed prior to forming copper pillars and associated solder caps. After forming the conductive probe plugs, copper pillars are formed on the respective conductive probe plugs by way of an electroplating process. Solder caps are formed on the top surface of respective copper pillars to facilitate conductive connections formed on a printed circuit board, for example. By forming the copper pillars with the underlying conductive probe plugs in this manner, hot wafer probe testing may be performed as an intermediate step thus improving the integrity and overall quality of the solder capped copper pillars.

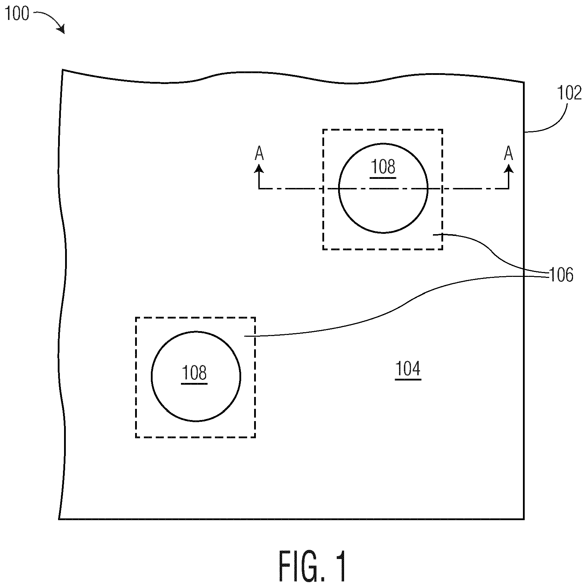

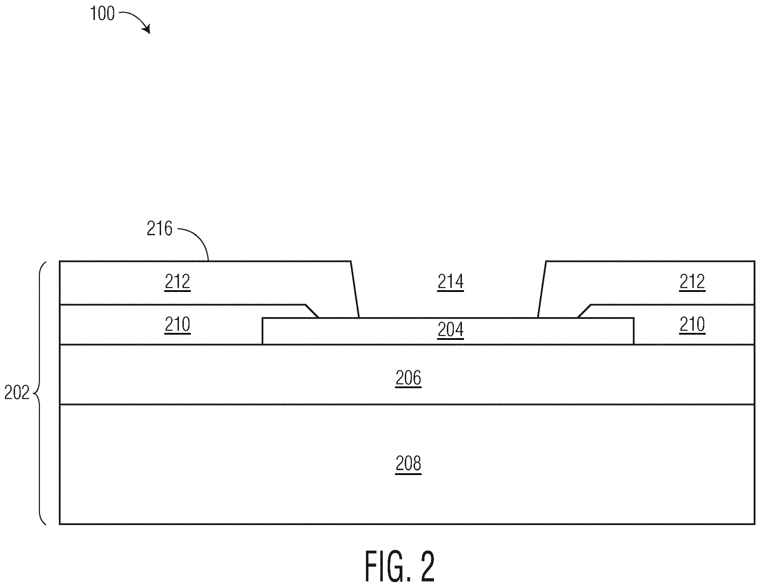

FIG. 1 illustrates, in a simplified plan view, a portion of an example semiconductor device 100 having a die pad contact feature in accordance with an embodiment. The device 100 includes a semiconductor die 102, a top-most passivation layer 104, underlying die pads 106, and copper pillars 108 formed over portions of the die pads 106. Each of the copper pillars 108 is depicted as a circular shape having a perimeter (e.g., circumference) illustrated with a solid line and each of the respective die pads 106 is depicted as a rectilinear shape having a perimeter illustrated with a dashed line. In this embodiment, each of the copper pillars 108 has a footprint (e.g., base perimeter/area) at the surface of the semiconductor die 102 located within the perimeter of a respective die pad 106. For example, the footprints of the each of the copper pillars 108 does not extend laterally outside of the perimeter of the respective die pads 106. The size, shape, location, and number of the die pads 106 and the respective copper pillars 108 in this embodiment are chosen for illustration purposes. Simplified cross-sectional views of the example semiconductor device 100 taken along line A-A of FIG. 1 at stages of manufacture are depicted in FIG. 2 through FIG. 9.

FIG. 2 illustrates, in a simplified cross-sectional view, the example semiconductor device 100 at a stage of manufacture in accordance with an embodiment. At this stage of manufacture, a semiconductor die 202 corresponding to the semiconductor die 102 of FIG. 1 is depicted. In this embodiment, the semiconductor die 202 includes a substrate region (e.g., bulk) 208, an active region (e.g., circuitry, interconnect) 206 formed at an active side of the semiconductor die, a die pad 204 conductively connected to the circuitry and/or interconnect of the active region, a first passivation layer 210 formed over the active side of the semiconductor die, and a second (e.g., final, top-most) passivation 212 formed over the passivation layer 210. For illustration purposes, the die pad 204 at a top portion of the active region 206 and the overlying passivation layers 210 and 212 are depicted. In this embodiment, the die pad 204 and a top surface 216 of the top passivation layer 212 depicted in FIG. 2 correspond to the die pad 106 and the top surface of the top-most passivation layer 104 depicted in FIG. 1.

The semiconductor die 202 is configured and arranged in an active side up orientation. An opening 214 through passivation layers 210 and 212 expose a portion of a top surface of the die pad 204. In this embodiment, the die pad 204 is formed from an aluminum or aluminum alloy material. In other embodiments, the die pad 204 may be formed from other suitable metal materials. The exposed portion of the die pad 204 at the active side is configured for connection to printed circuit board (PCB) by way of a copper pillar formed at subsequent stages, for example. In this embodiment, the passivation layer 210 may be formed from deposited oxide and nitride materials and the top passivation layer 212 may be formed from a deposited polyimide material. In other embodiments, the passivation layers 210 and 212 may be formed from other suitable materials. The semiconductor die 202 may include any number of conductive interconnect layers and passivation layers. The term "conductive," as used herein, generally refers to electrical conductivity unless otherwise described. The semiconductor die 202 may be formed from any suitable semiconductor material, such as silicon, germanium, gallium arsenide, gallium nitride, silicon nitride, silicon carbide, and the like. The semiconductor die 202 may further include any digital circuits, analog circuits, RF circuits, memory, processor, MEMS, sensors, the like, and combinations thereof. In this embodiment, the semiconductor die 202 may be provided as one of a plurality of semiconductor die arranged in a wafer form.

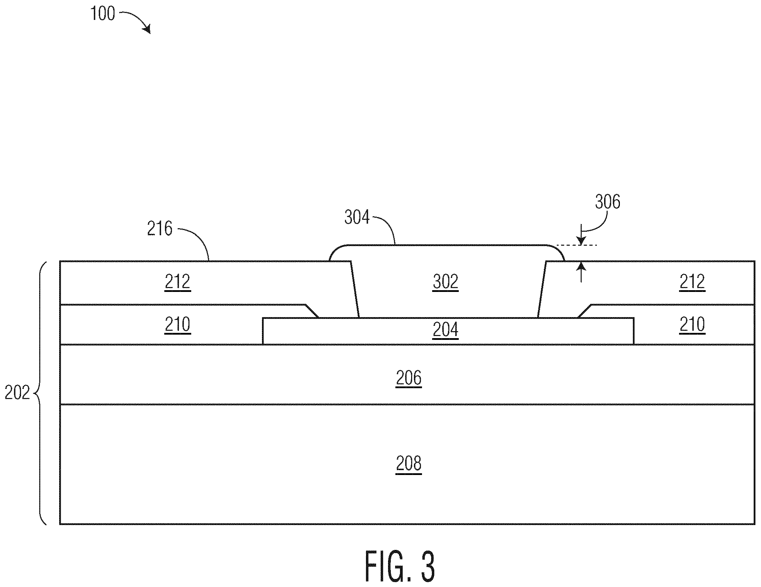

FIG. 3 illustrates, in a simplified cross-sectional view, the example semiconductor device 100 at a subsequent stage of manufacture in accordance with an embodiment. At this stage of manufacture, a conductive probe plug 302 is formed on the exposed portion of the die pad 204 by way of an electroless plating process. The conductive probe plug 302 is formed including a nickel or nickel alloy material by way of the maskless electroless plating process. A top surface 304 of the conductive probe plug 302 is configured to be substantially planar and extend above the plane of the top surface 216 of the top passivation layer 212. A portion of the conductive probe plug 302 overlaps a portion of the top surface 216 of the top passivation layer 212 immediately surrounding the opening 214 (of FIG. 2). In this embodiment, the conductive probe plug 302 is configured for contact by a probe needle of a test apparatus during a manufacturing test operation at a subsequent stage. The top surface 304 of the conductive probe plug 302 is configured to extend above the plane of the top surface 216 of the top passivation layer 212 by a predetermined distance dimension labeled 306. The predetermined distance 306 is chosen in a range of approximately 2-10 microns in this embodiment. For example, during a probe test operation, it is desirable for a probe needle to only contact the conductive probe plug 302 and not contact the top surface 216 of the surrounding portion of the top passivation layer 212.

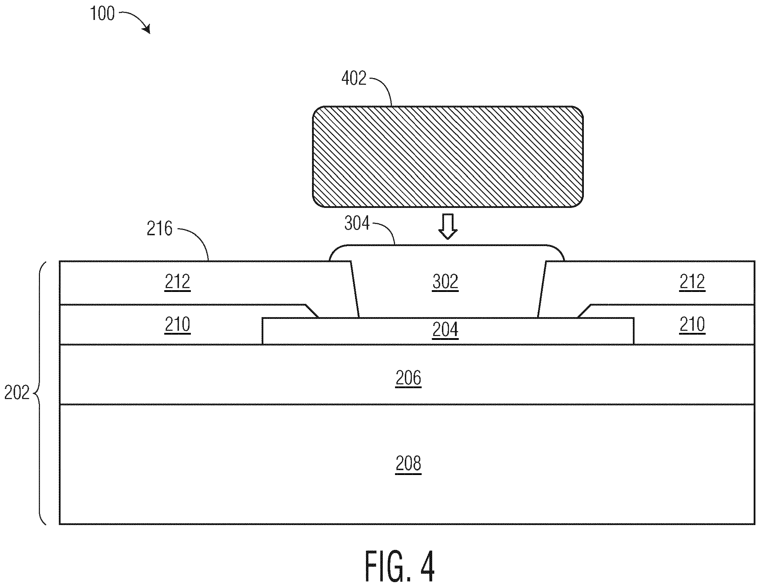

FIG. 4 illustrates, in a simplified cross-sectional view, the example semiconductor device 100 at a subsequent stage of manufacture in accordance with an embodiment. At this stage of manufacture, the semiconductor die 202 is subjected to a probe test operation. The probe test operation generally includes probe test apparatus configured to perform a wafer level manufacturing test by contacting the conductive probe plugs (302) of individual die sites using probe needles (402), for example. In this embodiment, a probe needle tip 402 is depicted over a respective conductive probe plug 302. The conductive probe plug 302 directly contacts the die pad 204 and serves as a conductive extension of the die pad. When the probe needle tip 402 engages with the conductive probe plug 302, electrical signals may be transmitted to and received from the semiconductor die under test by way of the test apparatus.

In this embodiment, the probe needle tip 402 is configured with a substantially flat (e.g., not pointed) tip portion. The nickel or nickel alloy material of the conductive probe plug 302 has a much higher melting point than a solder material allowing for high temperature (e.g., ~150 °C hot chuck) probe testing without the potential hazards associated with more conventional solder-capped copper pillar structures. Because the top surface 304 of the conductive probe plug 302 extends above the top surface 216 of the top passivation layer 212, the probe needle tip 402 contacts only the conductive probe plug 302. Here, the conductive probe plug 302 serves as a die pad contact feature by extending a die pad conductive surface above the top passivation layer thus allowing for hot chuck probing and subsequently providing a conductive foundation for a subsequent copper pillar formation.

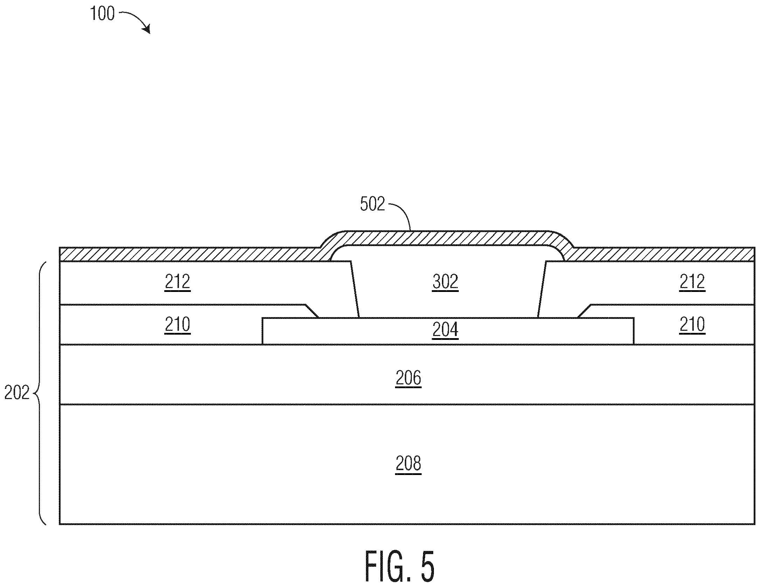

FIG. 5 illustrates, in a simplified cross-sectional view, the example semiconductor device 100 at a subsequent stage of manufacture in accordance with an embodiment. At this stage of manufacture, a barrier seed layer 502 is formed over the top of the semiconductor die 202. In this embodiment, the barrier seed layer 502 may be formed as a combination layer including a first sputtered barrier (e.g., tantalum, tantalum nitride, titanium) layer and a second sputtered seed (e.g., copper) layer. For illustration purposes, the barrier seed layer 502 is depicted as a single layer whether formed as a combination of layers or as a single layer. The barrier seed layer 502 is sputtered or otherwise deposited as a conformal layer covering the top passivation layer 212 and exposed portion of the conductive probe plug 302. In this embodiment, the barrier seed layer 502 is configured for copper plating at a subsequent stage of manufacture.

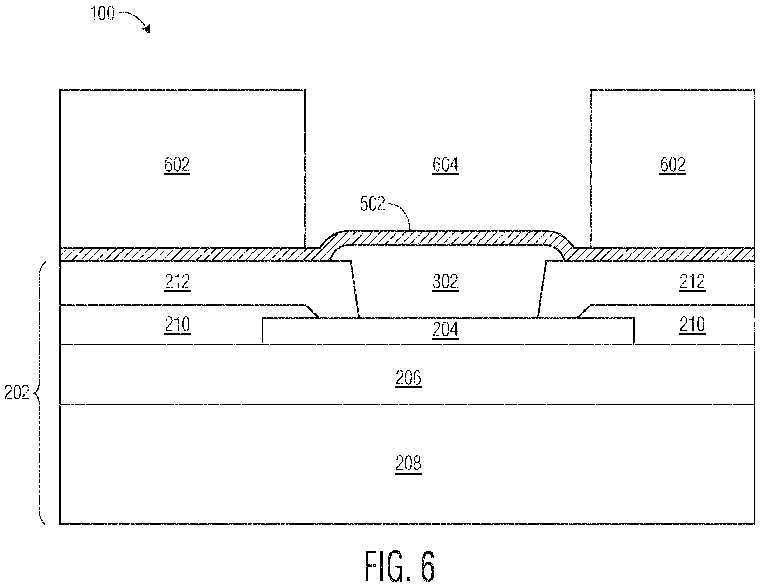

FIG. 6 illustrates, in a simplified cross-sectional view, the example semiconductor device 100 at a subsequent stage of manufacture in accordance with an embodiment. At this stage of manufacture, a photoresist layer 602 is applied on the barrier seed layer 502 and an opening 604 is formed over the conductive probe plug 302. In this embodiment, the photoresist layer 602 is deposited on the barrier seed layer 502 then patterned and etched to form the opening 604. Opening 604 is located over the conductive probe plug 302 such that the portion of the barrier seed layer 502 covering the conductive probe plug 302 is exposed through the photoresist layer 602. In this embodiment, the opening 604 is formed having a substantially cylindrical shape with a bottom circumference which surrounds the outer perimeter of the portion of the conductive probe plug 302 overlapping the top surface of the top passivation layer 212. In this embodiment, the diameter dimension of the opening 604 is predetermined based on a desired copper pillar diameter formed at a subsequent stage of manufacture.

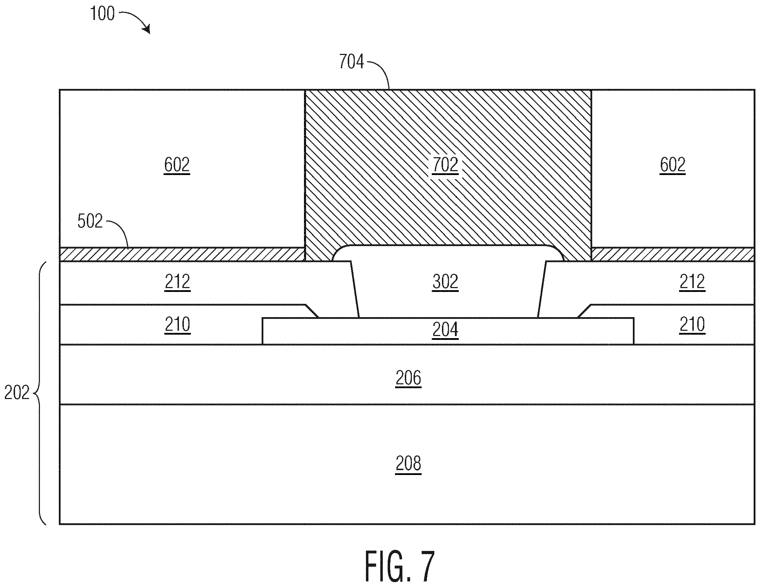

FIG. 7 illustrates, in a simplified cross-sectional view, the example semiconductor device 100 at a subsequent stage of manufacture in accordance with an embodiment. At this stage of manufacture, a copper pillar 702 is formed over the conductive probe plug 302 by way of an electroplating process. In this embodiment, after forming the opening 604 (of FIG. 6), the copper pillar 702 is electroplated on the exposed portion of the barrier seed layer 502 covering the conductive probe plug 302. The copper pillar 702 is electroplated to fill the opening 604 (of FIG. 6) such that a top surface 704 is substantially coplanar with a top surface of the photoresist 602 surrounding the copper pillar. In some embodiments, it may be desirable to form the top surface 704 of the copper pillar 702 with a small convex or concave curved surface.

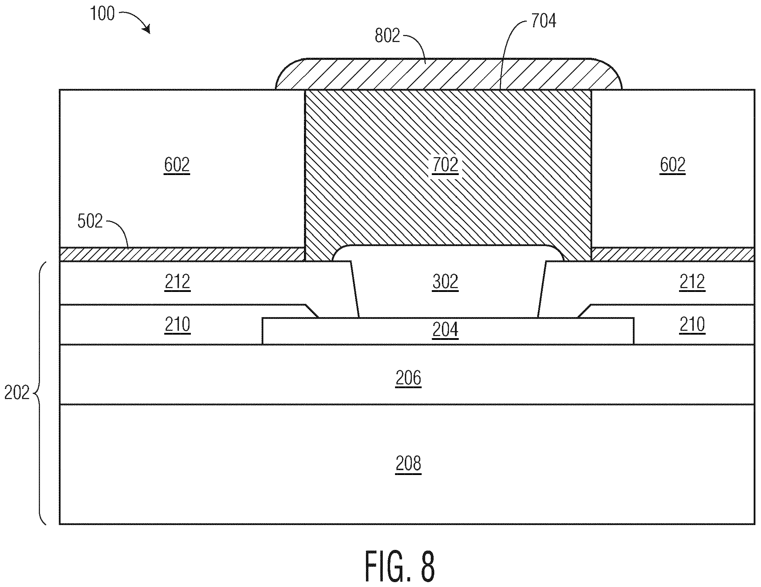

FIG. 8 illustrates, in a simplified cross-sectional view, the example semiconductor device 100 at a subsequent stage of manufacture in accordance with an embodiment. At this stage of manufacture, a solder material 802 is plated on the copper pillar 702. In this embodiment, after forming the copper pillar 702, the solder material 802 is plated on the exposed top surface 704 of the copper pillar. A portion of the solder material 802 overlaps a portion of the top surface of the photoresist layer 602 immediately surrounding the copper pillar 702. In this embodiment, the solder material 802 may include a solder alloy material such as tin-silver, for example.

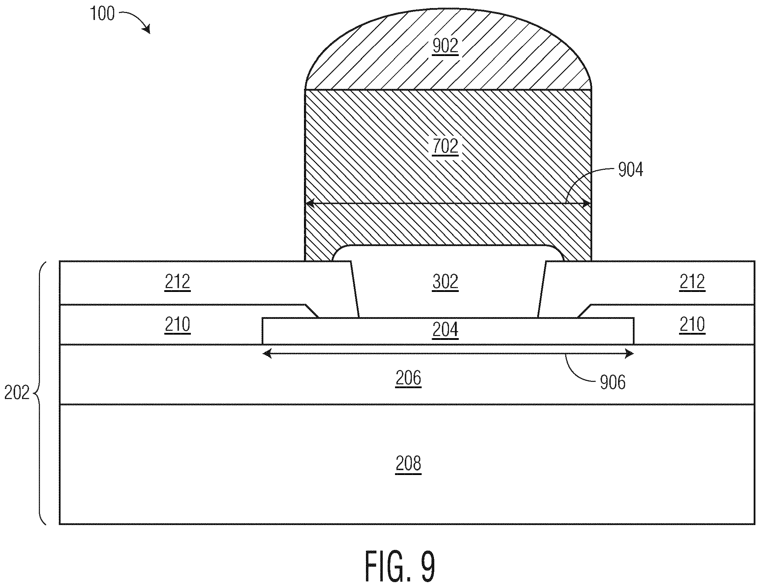

FIG. 9 illustrates, in a simplified cross-sectional view, the example semiconductor device 100 at a subsequent stage of manufacture in accordance with an embodiment. At this stage of manufacture, a solder cap 902 is formed on the copper pillar 702 by way of reflowing the solder material 802. In this embodiment, after the solder material 802 is plated on the copper pillar 702, the photoresist layer 602 and underlying barrier seed layer 502 of FIG. 8 are removed. The photoresist layer 602 is removed by way of a photoresist strip process and the remaining barrier seed layer 502 is removed by way of subsequent etch process, for example. After removing the photoresist layer 602 and underlying barrier seed layer 502, the semiconductor device 100 (e.g., in wafer form) is subjected to a heat (e.g., reflow) cycle. The solder material 802 of FIG. 8 is reflowed during the heat cycle thus forming the solder cap 902. In this embodiment, the resulting copper pillar 702 has a diameter dimension labeled 904 which is less than a width dimension of the die pad 204 labeled 906. Here, the width dimension 906 is characterized as the lesser of the width and length dimensions of the rectilinear shaped pad 204. Accordingly, the perimeter of the copper pillar 702 is located within the perimeter of the die pad 204. After forming the solder cap 902, an anti-oxidant/anti-corrosion material coating may be applied to the sidewalls of the copper pillar 702 to inhibit oxidation and corrosion of the copper pillar.

Generally, there is provided, a method including forming a conductive probe plug on an exposed portion of a die pad of a semiconductor die by way of an electroless plating process, a top surface of the conductive probe plug extending above a top surface of a top passivation layer of the semiconductor die; forming a copper pillar over the conductive probe plug by way of an electrolytic plating process, outer sidewalls of the copper pillar surround the top surface of the conductive probe plug; plating a top surface of the copper pillar with a solder plate material; and applying heat to reflow the solder plate material to form a solder cap on the top of the copper pillar. The conductive probe plug may include nickel. The top surface of the conductive probe plug extending above the top surface of the top passivation layer may be substantially planar. The top surface of the conductive probe plug may extend above the top surface of the top passivation layer by no more than 10 microns. The method may further include depositing a barrier seed layer on the top surface of the top passivation layer and the top surface of the conductive probe plug before forming the copper pillar by way of the electrolytic plating process. The method may further include depositing a photoresist layer on the barrier seed layer and forming an opening through the photoresist layer to expose a portion of the barrier seed layer over the top surface of the conductive probe plug. The method may further include removing the barrier seed layer exposed on the top surface of the top passivation layer after plating the top surface of the copper pillar with the solder plate material. A widest dimension of the copper pillar may be less than a lesser of a width and a length dimension of the die pad. The method may further include placing a probe needle directly on the top surface of the conductive probe plug during a test operation prior to forming the copper pillar.

In another embodiment, there is provided, a method including electroless plating a portion of a die pad exposed through an opening in a top passivation layer of a semiconductor die to form a conductive probe plug, a portion of the top surface of the conductive probe plug substantially planar and extending above a top surface of the top passivation layer; depositing a barrier seed layer on the top surface of the top passivation layer and the top surface of the conductive probe plug; depositing a photoresist layer on the barrier seed layer; forming an opening through the photoresist layer to expose a portion of the barrier seed layer over the top surface of the conductive probe plug; and forming a copper pillar on the exposed portion of the barrier seed layer over the conductive probe plug by way of an electrolytic plating process, a lower portion of the copper pillar completely surrounding the top surface of the conductive probe plug. An outer perimeter portion of the conductive probe plug may overlap a portion of the top surface of the top passivation layer. The substantially planar portion of the top surface of the conductive probe plug may substantially span a width of the opening. The method may further include plating a top surface of the copper pillar with a solder plate material and applying heat to reflow the solder plate material to form a solder cap on the top of the copper pillar. The electroless plating to form the conductive probe plug may include electroless plating a nickel or nickel alloy material. A perimeter of the copper pillar may be located within a perimeter of the die pad.

In yet another embodiment, there is provided, a semiconductor device including a conductive probe plug formed on a portion of a die pad through an opening in a top passivation layer of a semiconductor die, a portion of the top surface of the conductive probe plug substantially planar and extends above a top surface of the top passivation layer; a copper pillar formed over the top surface of the conductive probe plug and a portion of the top surface of the top passivation layer surrounding the top surface of the conductive probe plug such that a lower portion of the copper pillar completely surrounds the top surface of the conductive probe plug; and a solder cap formed on a top surface of the copper pillar. The die pad may include an aluminum or aluminum alloy material and the conductive probe plug may include a nickel or nickel alloy material. The portion of the top surface of the conductive probe plug may extend above the top surface of the top passivation layer by no more than 10 microns. A perimeter of the copper pillar may be located within a perimeter of the die pad. The top surface of the conductive probe plug may be configured for contact by a flat probe needle during a test operation before the copper pillar is formed.

By now, it should be appreciated that there has been provided a semiconductor device with a die pad contact feature. The die pad contact feature of the semiconductor device includes a raised conductive probe plug formed on die pads of a semiconductor die. Each conductive probe plug is formed by electroless (maskless) plating a nickel material on an exposed portion of a die pad. A top surface of each conductive probe plug extends above a top surface of a top passivation layer of the semiconductor die to facilitate high temperature wafer level probe testing with flat probe needle tips. In this manner, high temperature probe testing may be performed prior to forming copper pillars and associated solder caps. After forming the conductive probe plugs, copper pillars are formed on the respective conductive probe plugs by way of an electroplating process. Solder caps are formed on the top surface of respective copper pillars to facilitate conductive connections formed on a printed circuit board, for example. By forming the copper pillars with the underlying conductive probe plugs in this manner, hot wafer probe testing may be performed as an intermediate step thus improving the integrity and overall quality of the solder capped copper pillars.

A method of manufacturing a semiconductor device is provided. The method includes forming a conductive probe plug on an exposed portion of a die pad of a semiconductor die by way of an electroless plating process. A top surface of the conductive probe plug extends above a top surface of a top passivation layer of the semiconductor die. A copper pillar is formed over the conductive probe plug by way of an electrolytic plating process. Outer sidewalls of the copper pillar surround the top surface of the conductive probe plug. A top surface of the copper pillar is plated with a solder plate material and reflowed to form a solder cap on the top of the copper pillar.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
forming a conductive probe plug on an exposed portion of a die pad of a semiconductor die by way of an electroless plating process, a top surface of the conductive probe plug extending above a top surface of a top passivation layer of the semiconductor die;
forming a copper pillar over the conductive probe plug by way of an electrolytic plating process, outer sidewalls of the copper pillar surround the top surface of the conductive probe plug;
plating a top surface of the copper pillar with a solder plate material; and
applying heat to reflow the solder plate material to form a solder cap on the top of the copper pillar.

2. The method of claim 1, wherein the conductive probe plug comprises nickel.

3. The method of any preceding claim, wherein the top surface of the conductive probe plug extending above the top surface of the top passivation layer is substantially planar.

4. The method of any preceding claim, wherein the top surface of the conductive probe plug extends above the top surface of the top passivation layer by no more than 10 microns.

5. The method of any preceding claim, further comprising depositing a barrier seed layer on the top surface of the top passivation layer and the top surface of the conductive probe plug before forming the copper pillar by way of the electrolytic plating process.

6. The method of claim 5, further comprising:
depositing a photoresist layer on the barrier seed layer; and
forming an opening through the photoresist layer to expose a portion of the barrier seed layer over the top surface of the conductive probe plug.

7. The method of claim 5 or 6, further comprising removing the barrier seed layer exposed on the top surface of the top passivation layer after plating the top surface of the copper pillar with the solder plate material.

8. The method of any preceding claim, wherein a widest dimension of the copper pillar is less than a lesser of a width and a length dimension of the die pad.

9. The method of any preceding claim, further comprising placing a probe needle directly on the top surface of the conductive probe plug during a test operation prior to forming the copper pillar.

10. A semiconductor device comprising:
a conductive probe plug formed on a portion of a die pad through an opening in a top passivation layer of a semiconductor die, a portion of the top surface of the conductive probe plug substantially planar and extends above a top surface of the top passivation layer;
a copper pillar formed over the top surface of the conductive probe plug and a portion of the top surface of the top passivation layer surrounding the top surface of the conductive probe plug such that a lower portion of the copper pillar completely surrounds the top surface of the conductive probe plug; and
a solder cap formed on a top surface of the copper pillar.

11. The semiconductor device of claim 10, wherein the die pad comprises an aluminum or aluminum alloy material and the conductive probe plug comprises a nickel or nickel alloy material.

12. The semiconductor device of claim 10 or 11, wherein the portion of the top surface of the conductive probe plug extends above the top surface of the top passivation layer by no more than 10 microns.

13. The semiconductor device of any of claims 10 to 12, wherein a perimeter of the copper pillar is located within a perimeter of the die pad.

14. The semiconductor device of any of claims 10 to 13, wherein the top surface of the conductive probe plug is configured for contact by a flat probe needle during a test operation before the copper pillar is formed.
